# EUROPEAN PATENT APPLICATION

(11) **EP 2 432 040 A2**
(43) Date of publication of application: **21.03.2012**
(21) Application number: 10775055.6
(22) Date of filing: 29.04.2010
(51) Int. Cl.: H01L 51/52

(54) **ORGANIC LIGHT-EMITTING DIODE AND METHOD FOR MANUFACTURING SAME**

(30) Priority: 13.05.2009 KR 20090041540; 29.05.2009 KR 20090047783
(71) Applicant: Neoviewkolon Co., Ltd., Chungcheongnam-Do 350-883 (KR)
(72) Inventor: HA, Young Bo, Gimhae Si Gyeongsangnam-Do 621-807 (KR); SHIN, Eun Chul, Seoul 138-821 (KR); KIM, Young Eun, Seoul 133-846 (KR); IM, Woo Bin, Chungcheongnam-Do 350-809 (KR); PARK, Hyun Sik, Daejeon 305-510 (KR)
(74) Representative: Krauns, Christian
(86) International application number: PCT/KR2010/002721
(87) International publication number: WO 2010/131853

(57) **Abstract**

Disclosed is an organic light emitting diode, in which the light transmittance of a transparent cathode is improved, and which includes a substrate, a first electrode formed on the substrate, an organic layer formed on the first electrode, a second electrode formed on the organic layer, and a transparent layer formed at either one or both of a position between the organic layer and the second electrode and a position on the upper surface of the second electrode and including any one selected from among an oxide, a nitride, a salt and mixtures thereof, so that the formation of the transparent layer on the cathode results in increased light transmittance and decreased resistance, thereby improving electrical performance of products. A method of manufacturing the organic light emitting diode is also provided.

## Description

### Technical Field

The present invention relates to an organic light emitting diode, and more particularly to an organic light emitting diode in which the light transmittance of a transparent cathode is improved, and to a method of manufacturing the same.

### Background Art

Typically, an organic light emitting diode (OLED) includes a substrate, a bottom electrode formed on the substrate, an organic layer formed on the bottom electrode and a top electrode formed on the organic layer.

The OLED emits light using electrical conduction between an anode used as the bottom electrode and a cathode used as the top electrode. Specifically, the light emission of the OLED occurs at the organic layer disposed between the top electrode and the bottom electrode by means of electrons of the top electrode and holes of the bottom electrode.

OLEDs are classified into, depending on the light emission manner, transparent OLEDs which emit light through a top electrode and a bottom electrode, top OLEDs that emit light through a top electrode, and bottom OLEDs that emit light through a bottom electrode.

The light emission manner of the OLED is achieved by either or both of the electrodes that are transparent among the top electrode and the bottom electrode. In the case of the transparent OLED, both the top electrode and the bottom electrode must be transparent. Typically, the bottom electrode may be a transparent indium-tin-oxide (ITO) electrode, and the top electrode may be a transparent metal film. As such, when the thickness of such a metal film is reduced, transmittance may be increased.

However, if the thickness of the top electrode is reduced to increase the transmittance of the top electrode, the sheet resistance of the top electrode may increase. Specifically, as the thickness of the top electrode is reduced in order to increase the transmittance thereof, resistance thereof increases, undesirably deteriorating total performance of the OLED.

### Disclosure

### Technical Problem

Accordingly, the present invention has been made keeping in mind the problems encountered in the related art and the present invention is intended to provide an OLED, which is able to increase the transmittance of a cathode.

Also the present invention is intended to provide an OLED, which is efficiently configured such that resistance of a cathode is prevented from increasing in proportion to the increase in transmittance thereof.

Also the present invention is intended to provide a method of manufacturing the OLED.

The advantages of the present invention are not limited to the above-described advantages, and those skilled in the art will clearly understand other advantages which are not described here from a description of the accompanying claims.

### Technical Solution

An aspect of the present invention provides an OLED, including a substrate, a first electrode formed on the substrate, an organic layer formed on the first electrode, a second electrode formed on the organic layer, and a transparent layer formed at either one or both of a position between the organic layer and the second electrode and a position on the upper surface of the second electrode and including any one selected from the group consisting of an oxide, a nitride, a salt and mixtures thereof.

In this aspect, the oxide may include any one selected from the group consisting of MoO₃, ITO, IZO, IO, ZnO, TO, TiO₂, SiO₂, WO₃, Al₂O₃, Cr₂O₃, TeO₂, and SrO₂.

Also, the nitride may include any one selected from the group consisting of Si₃N₄ and AlN.

Also, the salt may include any one selected from the group consisting of Cs₂CO₃, Li₂CO₃, K₂CO₃, Na₂CO₃, LiF, CsF, and ZnSe.

Also, the transparent layer may have a thickness ranging from 0.1 nm to less than 100 nm.

Also, the organic layer may include an electron transporting layer formed by doping any one selected from the group consisting of a metal having low work function and a compound thereof, in order to facilitate the injection of electrons from the second electrode.

As such, the metal having low work function may include any one selected from the group consisting of Cs, Li, Na, K, and Ca.

Furthermore, the compound thereof may include any one selected from the group consisting of Li-Al, LiF, CsF, and Cs₂CO₃.

Also, the OLED may exhibit a transmittance of 70 - 99% depending on a wavelength (nm).

Another aspect of the present invention provides a method of manufacturing an OLED, including forming a first electrode on a substrate, forming an organic layer on the first electrode, forming a second electrode on the organic layer, and forming a transparent layer including any one selected from the group consisting of an oxide, a nitride, a salt and mixtures thereof at either one or both of a position between the organic layer and the second electrode and a position on the upper surface of the second electrode.

Hereinafter, the present invention will be described in detail with reference to the attached drawings.

### Advantageous Effects

According to the present invention, the OLED is configured such that a transparent layer including any one selected from among an oxide, a nitride, a salt and mixtures thereof is formed at either one or both of a position between an organic layer and a second electrode (cathode) and a position on the upper surface of the second electrode, thereby achieving double-sided light emission and increasing transmittance.

Also, according to the present invention, because the transparent layer is formed of any one selected from among an oxide, a nitride, a salt and mixtures thereof, the internal resistance of the second electrode can be prevented from increasing, thus improving electrical performance of products.

### Description of Drawings

FIG. 1 is a cross-sectional view showing an OLED according to an embodiment of the present invention;
FIG. 2 is a graph showing transmittance which depends on the transparent layer of the OLED according to the present invention;
FIG. 3 is a graph showing luminance which depends on the transparent layer of the OLED according to the present invention;
FIG. 4 is a graph showing transmittance when the transparent layer of the OLED according to the present invention is formed of an oxide, a salt, or a mixture thereof; and
FIG. 5 is a flowchart showing a process of manufacturing the OLED according to the present invention.

### <Description of the Reference Numerals in the Drawings>

- 1:: OLED 10: substrate
- 30:: first electrode 50: second electrode
- 70:: organic layer 72: hole injection layer
- 74:: hole transporting layer 76: emissive layer
- 78:: electron transporting layer 79: electron injection layer
- 90:: transparent layer 91: first transparent layer
- 92:: second transparent layer

### Best Mode

The features and advantages of the present invention will be more clearly understood from the following detailed description taken in conjunction with the accompanying drawings. Although the preferred embodiments of the present invention have been disclosed for illustrative purposes, those skilled in the art will appreciate that various modifications, additions and substitutions are possible, without departing from the scope and spirit of the invention as disclosed in the accompanying claims. Throughout the drawings, the same reference numerals refer to the same or similar elements, and redundant descriptions are omitted.

Hereinafter, a detailed description will be given of an OLED and a method of manufacturing the same according to the present invention with reference to the accompanying drawings. Also in the description, in the case where known techniques pertaining to the present invention are regarded as unnecessary because they would make the characteristics of the invention unclear and also for the sake of description, the detailed descriptions thereof may be omitted.

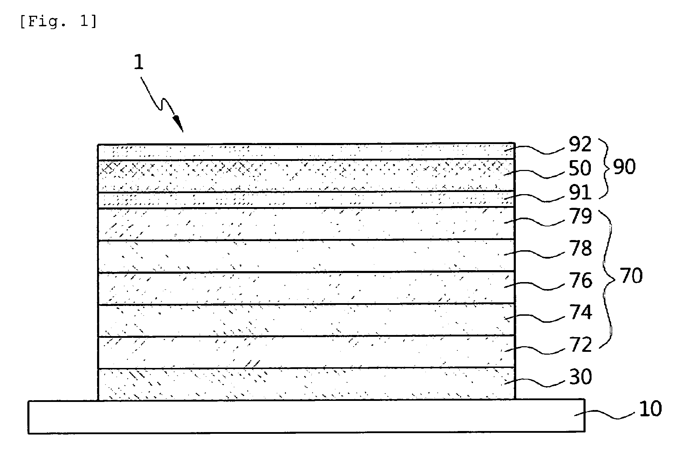

As shown in FIG. 1, the OLED 1 according to the present invention may include a substrate 10, a first electrode 30, a second electrode 50, an organic layer 70, and a transparent layer 90.

The substrate 10 supports the first electrode 30, the second electrode 50, the organic layer 70 and the transparent layer 90. The substrate 10 may be formed of a glass material or a plastic material, which is transparent so as to permit emitted light to pass therethrough.

The first electrode 30 is typically referred to as a bottom electrode, and is formed on the substrate 10. The first electrode 30 is an anode which is a positive electrode and is formed on the substrate 10 using sputtering, ion plating or thermal evaporation using an e-gun. As such, according to an exemplary embodiment of the present invention, the first electrode 30 may be a transparent ITO electrode, or alternatively may be a transparent indium-zinc-oxide electrode.

The second electrode 50 is typically referred to as a top electrode disposed to face the first electrode 30, and is formed on the organic layer 70. The second electrode 50 is a cathode which is a negative electrode oppositely charged to the first electrode 30 which is the positive electrode. The second electrode 50 may be formed of any one selected from among silver (Ag), aluminum (Al) and a magnesium-silver (Mg-Ag) alloy, so that it is transparent.

The organic layer 70 is disposed between the first electrode 30 and the second electrode 50, and emits light using electrical conduction between the first electrode 30 and the second electrode 50. The organic layer 70 includes a hole injection layer (HIL) 72, a hole transporting layer (HTL) 74, an emissive layer (EML) 76, an electron transporting layer (ETL) 78 and an electron injection layer (EIL) 79, in order to emit light using electrical conduction between the first electrode 30 and the second electrode 50.

The organic layer 70 may be formed between the first electrode 30 and the second electrode 50 using spin coating, thermal evaporation, spin casting, sputtering, e-beam evaporation or chemical vapor deposition (CVD).

Specifically, the hole injection layer 72 functions to inject holes from the first electrode 30, and the hole transporting layer 74 functions to transport the holes injected from the hole injection layer 72 so as to meet with electrons of the second electrode 50.

The electron injection layer 79 functions to inject electrons from the second electrode 50, and the electron transporting layer 78 functions to transport the electrons injected from the electron injection layer 79 so as to meet with the holes transported from the hole transporting layer 74 at the emissive layer 76.

The electron transporting layer 78 may be formed by doping any one selected from among a metal having low work function and a compound thereof, in order to facilitate the injection of the electrons from the second electrode 50, and may be applied regardless of whether the electron injection layer 79 is provided or not.

As such, examples of the metal having low work function may include Cs, Li, Na, K, and Ca, and examples of the compound thereof may include Li-Al, LiF, CsF, and Cs₂CO₃.

The emissive layer 76 is disposed between the hole transporting layer 74 and the electron transporting layer 78 and thus emits light by means of the holes from the hole transporting layer 74 and the electrons from the electron transporting layer 78. Specifically, light emission takes place by virtue of the holes and the electrons which meet and recombine with each other in the emissive layer 76, that is, at the interfaces between the hole transporting layer 74 and the electron transporting layer 78.

The transparent layer 90 may be formed at either one or both of a position between the organic layer 70 and the second electrode 50 and a position on the upper surface of the second electrode 50. For example, the transparent layer 90 may be formed on both the upper surface and the lower surface of the second electrode 50, or alternatively only on either of the lower surface and the upper surface of the second electrode 50.

In the present embodiment, the configuration in which the transparent layer 90 is formed on both of the upper and lower surfaces of the second electrode 50 is illustrated. However, the present invention is not limited thereto, and it goes without saying that the configuration in which the transparent layer is formed only on either of the lower and upper surfaces of the second electrode 50 be able to be applied as well.

The transparent layer 90 may include a first transparent layer 91 formed between the organic layer 70 and the second electrode 50, and a second transparent layer 92 formed on the upper surface of the second electrode 50.

Particularly, the first transparent layer 91 may be formed between the electron injection layer 79 of the organic layer 70 and the second electrode 50, or may be formed in the electron injection layer 79 itself. Also, the second transparent layer 92 may be formed on the upper surface of the second electrode 50 opposite the surface on which the first transparent layer 91 is formed.

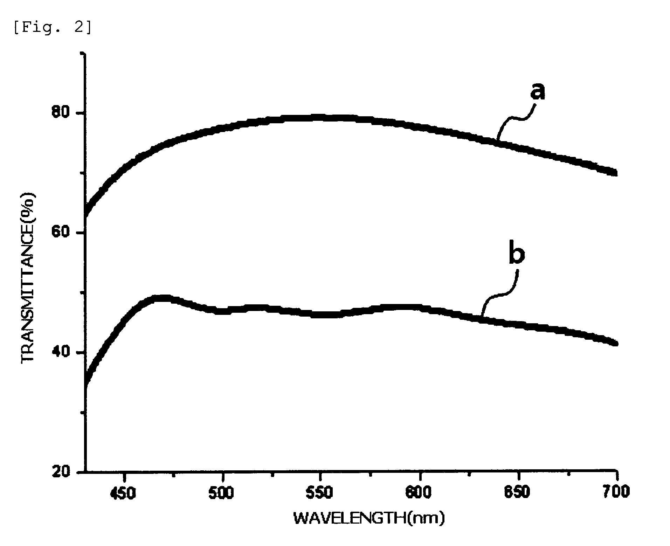

Herein, the transparent layer 90 plays a role in imparting the second electrode 50 with transparency and high transmittance. The transparent layer 90 is provided in the form of a thin film to thus reduce the sheet resistance of the second electrode 50, thereby preventing the performance of the OLED 1 from deteriorating. The properties of the transparent layer 90 are specified with reference to FIGS. 2 to 4 after the following description of an oxide, a nitride, a salt and mixtures thereof is given.

The transparent layer 90 according to the present invention may include any one selected from among an oxide, a nitride, a salt and mixtures thereof.

Examples of the oxide may include MoO₃, ITO, IZO, IO, ZnO, TO, TiO₂, SiO₂, WO₃, Al₂O₃, Cr₂O₃, TeO₂, and SrO₂, and examples of the nitride may include Si₃N₄, and A1N. Also, examples of the salt may include Cs₂CO₃, Li₂CO₃, K₂CO₃, Na₂CO₃, LiF, CsF, and ZnSe.

When the transparent layer 90 is formed using an oxide, a nitride, a salt or a mixture thereof, it preferably exhibits superior transmittance and luminance as shown in FIGS. 2 to 4. In addition to the above materials, any material may be used so long as the second electrode 50 is transparent and has high transmittance.

As for the transparent layer 90, the first transparent layer 91 and the second transparent layer 92 may be formed of the same material, or alternatively may be formed of different materials. For example, the first transparent layer 91 may include an oxide, and the second transparent layer 92 may include a nitride, a salt or a mixture thereof. Alternatively, the first transparent layer 91 may include a nitride, and the second transparent layer 92 may include an oxide, a salt or a mixture thereof. Alternatively, the first transparent layer 91 may include a salt, and the second transparent layer 92 may include an oxide, a nitride or a mixture thereof.

The thickness of the transparent layer 90 may be set in the range from 0.1 nm to less than 100 nm. The reason why the thickness of the transparent layer 90 is limited is that if the thickness of the transparent layer 90 is less than 0.1 nm, transmittance is increased but resistance may also increase proportionally thereto, undesirably deteriorating the performance of the OLED 1.

In contrast, if the thickness of the transparent layer 90 is 100 nm or more, resistance may decrease and thus the performance of the OLED does not deteriorate, but the transmittance is lowered in inverse proportion to the increase in the thickness of the transparent layer 90. Also, according to an exemplary embodiment of the present invention, the transparent layer 90 may be formed using thermal evaporation.

With reference to FIGS. 2 to 4, the properties of the OLED 1 according to the present invention are described below.

FIG. 2 is a graph showing the transmittance of the OLED 1 depending on whether the transparent layer 90 is provided or not. In FIG. 2, curve "a" depicts the transmittance of the OLED 1 with the transparent layer 90 according to the present invention, and curve "b" depicts the transmittance of the OLED 1 without the transparent layer 90, unlike the present invention.

The OLED 1 according to the present invention may exhibit a transmittance of 70 - 99% depending on a wavelength (nm). For example, as shown in FIG. 2, the OLED 1 according to the present invention may show a transmittance of about 80% at 550 nm, and the OLED 1 without the transparent layer 90 may show a transmittance of about 47% at 550 nm. Thereby, the transmittance of the OLED 1 with the transparent layer 90 can be seen to be 1.7 times higher than that of the OLED 1 without the transparent layer 90.

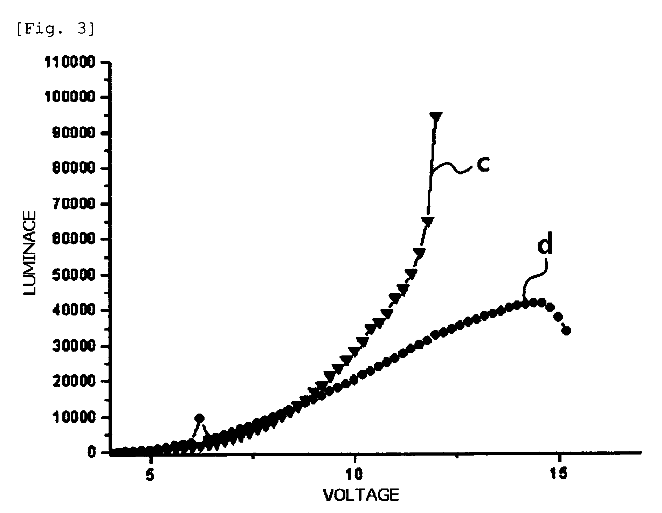

FIG. 3 is a graph showing the luminance of the OLED 1 depending on whether the transparent layer 90 is provided or not. In FIG. 3, curve "c" depicts the luminance of the OLED 1 with the transparent layer 90 according to the present invention, and curve "d" depicts the luminance of the OLED 1 without the transparent layer 90.

The OLED 1 with the transparent layer 90 manifests a luminance of about 25,000 at a voltage of 10 V, whereas the OLED 1 without the transparent layer 90 shows a luminance of about 20,000 at 10 V. From this, it can be seen that there is a 1.25 times difference in the luminance depending on whether the transparent layer 90 is provided or not.

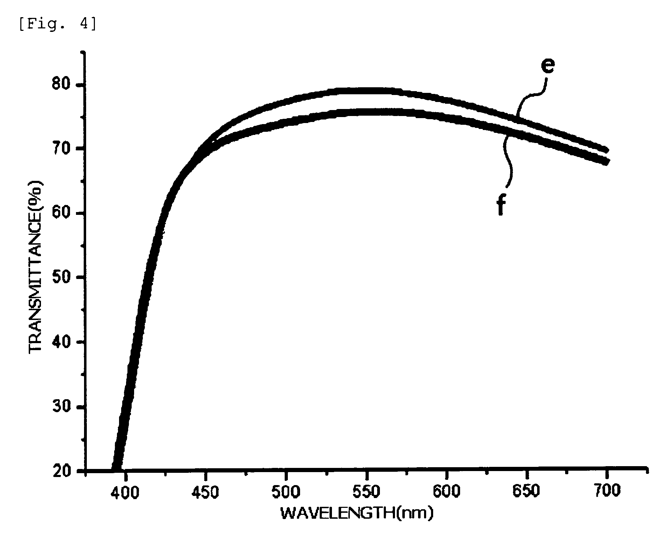

In FIG. 4, curve "e" depicts the transmittance when the transparent layer 90 is formed of an oxide such as MoO₃, ITO, IZO, IO, ZnO, TO, TiO₂, SiO₂, WO₃, Al₂O₃, Cr₂O₃, TeO₂, or SrO₂, and curve "f" depicts the transmittance when the transparent layer 90 is formed of a salt such as Cs₂CO₃, Li₂CO₃, K₂CO₃, Na₂CO₃, LiF, CsF, or ZnSe.

As shown in FIG. 4, the transmittance is determined to be about 80% when the transparent layer 90 is formed of an oxide, and is determined to be about 75% when the transparent layer 90 is formed of a salt. Although the transmittance is about 5% higher when using the transparent layer 90 formed of an oxide than when using the transparent layer 90 formed of a salt, this is a small difference. Hence, an oxide, a salt and mixtures thereof may be selectively used as in the embodiment of the present invention.

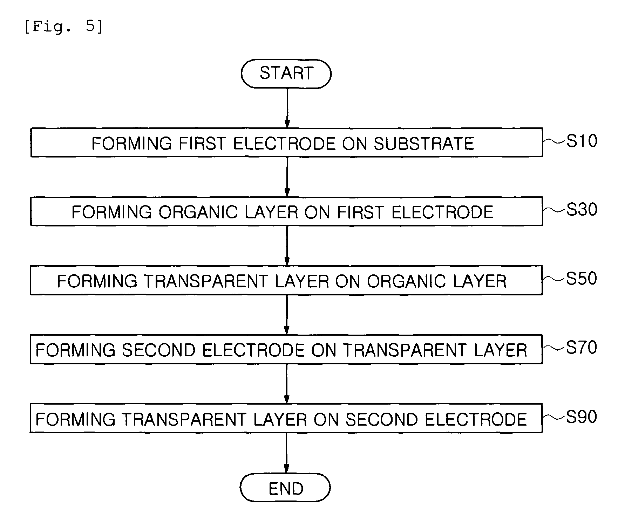

Turning now to FIG. 5, a method of manufacturing the OLED 1 according to the present invention is described below.

First, a first electrode 30 which is a positive electrode is formed on a substrate 10 (S10).

Subsequently, an organic layer 70 is formed on the first electrode 30 which has been formed on the substrate 10 (S30). The organic layer 70 formed on the first electrode 30 includes a hole injection layer 72, a hole transporting layer 74, an emissive layer 76, an electron transporting layer 78 and an electron injection layer 79, which are sequentially formed.

Subsequently, a first transparent layer 91 is formed on the organic layer 70 (S50). According to an exemplary embodiment of the present invention, the first transparent layer 91 may include an oxide such as MoO₃, ITO, IZO, IO, ZnO, TO, TiO₂, SiO₂, WO₃, Al₂O₃, Cr₂O₃, TeO₂, or SrO₂. Taking into consideration the resistance and transmittance, the first transparent layer 91 is formed to a thickness ranging from 0.1 nm to less than 100 nm.

Subsequently, a second electrode 50 is formed on the first transparent layer 91 (S70). The second electrode 50 which is a negative electrode may include a metal film. The metal film used as the second electrode 50 may include any one selected from among Ag, Al and an Mg-Ag alloy.

Subsequently, a second transparent layer 92 is formed on the second electrode 50 (S90). The second transparent layer 92 may include an oxide as in S50. However, the second transparent layer 92 formed on the second electrode 50 may include a nitride such as Si₃N₄ or A1N, a salt such as Cs₂CO₃, Li₂CO₃, K₂CO₃, Na₂CO₃, LiF, CsF or ZnSe, or a mixture thereof.

When the transparent layer 90 is formed on both surfaces of the second electrode 50 in this way, double-sided light emission is possible and the transmittance may be increased.

Furthermore, as the transparent layer 90 is formed, the thickness of the second electrode 50 may be adjusted, thus improving the transmittance and electrical performance.

## Claims

1. An organic light emitting diode, comprising:
a substrate;
a first electrode formed on the substrate;
an organic layer formed on the first electrode;
a second electrode formed on the organic layer; and
a transparent layer formed at either one or both of a position between the organic layer and the second electrode and a position on an upper surface of the second electrode and comprising any one selected from the group consisting of an oxide, a nitride, a salt and mixtures thereof.

2. The organic light emitting diode as set forth in claim 1, wherein the oxide comprises any one selected from the group consisting of MoO₃, ITO, IZO, IO, ZnO, TO, TiO₂, SiO₂, WO₃, Al₂O₃, Cr₂O₃, TeO₂, and SrO₂.

3. The organic light emitting diode as set forth in claim 1, wherein the nitride comprises any one selected from the group consisting of Si₃N₄ and A1N.

4. The organic light emitting diode as set forth in claim 1, wherein the salt comprises any one selected from the group consisting of Cs₂CO₃, Li₂CO₃, K₂CO₃, Na₂CO₃, LiF, CsF, and ZnSe.

5. The organic light emitting diode as set forth in claim 1, wherein the transparent layer has a thickness ranging from 0.1 nm to less than 100 nm.

6. The organic light emitting diode as set forth in claim 1, wherein the organic layer comprises an electron transporting layer formed by doping any one selected from the group consisting of a metal having low work function and a compound thereof, in order to facilitate injection of electrons from the second electrode.

7. The organic light emitting diode as set forth in claim 6, wherein the metal having low work function comprises any one selected from the group consisting of Cs, Li, Na, K, and Ca.

8. The organic light emitting diode as set forth in claim 6, wherein the compound thereof comprises any one selected from the group consisting of Li-Al, LiF, CsF, and Cs₂CO₃.

9. The organic light emitting diode as set forth in claim 1, which exhibits a transmittance of 70 - 99% depending on a wavelength (nm).

10. A method of manufacturing an organic light emitting diode, comprising:
forming a first electrode on a substrate;
forming an organic layer on the first electrode;
forming a second electrode on the organic layer; and
forming a transparent layer comprising any one selected from the group consisting of an oxide, a nitride, a salt and mixtures thereof, at either one or both of a position between the organic layer and the second electrode and a position on an upper surface of the second electrode.

11. The method as set forth in claim 10, wherein the oxide comprises any one selected from the group consisting of MoO₃, ITO, IZO, IO, ZnO, TO, TiO₂, SiO₂, WO₃, Al₂O₃, Cr₂O₃, TeO₂, and SrO₂.

12. The method as set forth in claim 10, wherein the nitride comprises any one selected from the group consisting of Si₃N₄ and A1N.

13. The method as set forth in claim 10, wherein the salt comprises any one selected from the group consisting of Cs₂CO₃, Li₂CO₃, K₂CO₃, Na₂CO₃, LiF, CsF, and ZnSe.

14. The method as set forth in claim 10, wherein the forming the transparent layer is performed by forming any one selected from the group consisting of an oxide, a nitride, a salt and mixtures thereof to a thickness ranging from 0.1 nm to less than 100 nm.

15. The method as set forth in claim 10, wherein the organic layer comprises an electron transporting layer formed by doping any one selected from the group consisting of a metal having low work function and a compound thereof, in order to facilitate injection of electrons from the second electrode.

16. The method as set forth in claim 15, wherein the metal having low work function comprises any one selected from the group consisting of Cs, Li, Na, K, and Ca.

17. The method as set forth in claim 15, wherein the compound thereof comprises any one selected from the group consisting of Li-Al, LiF, CsF, and Cs₂CO₃.
